# EUROPEAN PATENT SPECIFICATION

(11) **EP 4 081 006 B1**
(45) Date of publication and mention of the grant of the patent: **30.10.2024**
(21) Application number: 20909331.9
(22) Date of filing: 11.08.2020
(51) Int. Cl.: H05K 7/20

(54) **HEAT DISSIPATION DEVICE, CIRCUIT BOARD ASSEMBLY, AND ELECTRONIC APPARATUS**
WÄRMEABLEITUNGSVORRICHTUNG, LEITERPLATTENANORDNUNG UND ELEKTRONISCHES GERÄT
DISPOSITIF DE DISSIPATION DE CHALEUR, ENSEMBLE CARTE DE CIRCUIT IMPRIMÉ ET APPAREIL ÉLECTRONIQUE

(30) Priority: 30.12.2019 CN 201911398409
(43) Date of publication of application: 26.10.2022
(73) Proprietor: Huawei Digital Power Technologies Co., Ltd., Shenzhen, Guangdong 518043 (CN)
(72) Inventor: WEI, Longhe, Shenzhen, Guangdong 518129 (CN); CHEN, Jun, Shenzhen, Guangdong 518129 (CN); LIAN, Zhisheng, Shenzhen, Guangdong 518129 (CN); LI, Quanming, Shenzhen, Guangdong 518129 (CN)
(74) Representative: Maiwald GmbH
(86) International application number: PCT/CN2020/108348
(87) International publication number: WO 2021/135239

(56) References cited:
- CN-A- 101 202 529
- JP-A- 2007 329 338
- JP-A- 2019 102 738
- US-A- 5 650 914
- US-A1- 2005 168 941
- US-A1- 2011 149 537
- US-A1- 2014 211 421
- US-A1- 2017 094 830
- US-B1- 6 275 374

## Description

### TECHNICAL FIELD

This application relates to the field of heat dissipation technologies, and in particular, to a heat dissipation apparatus, a circuit board assembly, and an electronic device

### BACKGROUND

With the advent of the era of high-speed communication, energy consumption of an electronic device such as a communication base station keeps increasing. A distributed power unit (Distributed Processing Unit, DPU) is one of main products for supplying power to future base stations. As a power requirement on the distributed power unit increases, a corresponding device generates a lot of heat. If the heat cannot be discharged in time, normal operation and a service life of the device may be severely affected.

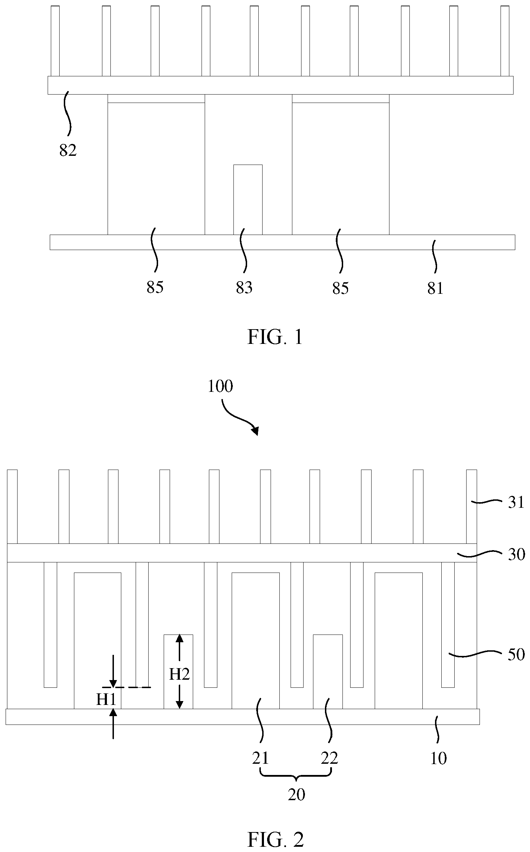

Currently, heat dissipation is usually performed on a to-be-cooled device in the distributed power unit by using a heat sink. For example, refer to FIG. 1. A plurality of to-be-cooled devices 85 are mounted on a circuit board 81, heat sinks 82 are attached to upper portions of the to-be-cooled devices 85 by using an interface material, and the heat sinks 82 cannot be directly attached to some relatively small to-be-cooled devices 83 due to an excessively small size. In an actual working process, heat of the to-be-cooled devices 85 is directly dissipated into an external environment by using the heat sinks 82. The heat of the relatively small to-be-cooled devices 83 is first dissipated into the air, is subsequently transferred to the heat sinks 82 from the air, and finally is dissipated into an external environment by using the heat sinks 82.

However, in the foregoing heat dissipation solution, some to-be-cooled devices may be relatively far away from the heat sinks. For example, a to-be-cooled device with a relatively small size is relatively far away from the heat sinks. Therefore, when heat is transferred to the heat sinks by the air, thermal resistance is relatively large, a high-temperature region may be formed locally near the small-size device. As a result, the device is over temperature, which leads to low heat dissipation efficiency of the heat sinks.

US 6,275,374 B1 describes an electronic device that protects an electronic component on a motherboard from vibration and impact. US2011/149537A1 discloses a circuit board assembly according to the preamble of the independent claim 1.

### SUMMARY

Embodiments of this application provide circuit board assembly comprising a heat dissipation apparatus, to achieve relatively high heat dissipation efficiency of the heat dissipation apparatus. The present invention is defined by the subject-matter of the independent claims. Additional features of the invention are presented in the dependent claims.

A first aspect of embodiments of this application, said first aspect not being covered by the claimed invention, provides a heat dissipation apparatus, applicable to a circuit board, where a plurality of heating elements are disposed on the circuit board, the heat dissipation apparatus includes a substrate, at least one heat conductor is disposed on one surface that is of the substrate and that faces the circuit board, one end of the heat conductor is connected to the substrate, and the other end extends toward the circuit board and is close to the heating elements.

At least one heat conductor is disposed on the one surface that is of the substrate and that faces the circuit board, one end of the heat conductor is connected to the substrate, and the other end of the heat conductor extends toward the circuit board and is close to the heating elements. Heat of each heating element, for example, a heating element relatively far away from the substrate, can be rapidly transferred to the substrate by using the heat conductor with relatively small thermal resistance, and then is dissipated from the substrate into an external environment. This effectively reduces thermal conduction resistance from the heating element to the substrate, and improves heat dissipation efficiency of the heat dissipation apparatus.

In a possible implementation, one end of at least one heat conductor extends between a high-temperature element and a low-temperature element that are adjacent in the heating elements, to isolate the high-temperature element from the low-temperature element by using the heat conductor.

Temperature partitioning can be implemented by isolating the high-temperature element from the low-temperature element by using the heat conductor, to ensure a low-temperature application environment of the low-temperature element, thereby avoiding over-temperature caused by baking the low-temperature device by the high-temperature device.

In a possible implementation, a heat insulation layer is disposed on the heat conductor between the high-temperature element and the low-temperature element, and the heat insulation layer faces the low-temperature element.

The heat insulation layer is disposed on one side that is of the heat conductor and that faces the low-temperature element, so that heat radiated from the high-temperature element to the low-temperature element can be blocked by the heat insulation layer, thereby improving a heat insulation effect of the heat conductor.

In a possible implementation, the heat conductor is an annular heat conductor, and the annular heat conductor is disposed by enclosing an outer side of the high-temperature element adjacent to the low-temperature element, or a plurality of spaced heat conductors are disposed on an outer side of the high-temperature element adjacent to the low-temperature element.

The heat conductor is disposed by enclosing the outer side of the high-temperature element, so that a heat insulation barrier can be formed around the high-temperature element. In one aspect, heat of the high-temperature element is more easily transferred to the substrate by using the heat conductor, and in another aspect, the heat of the high-temperature element is better prevented from being radiated to the low-temperature element around the high-temperature element.

In a possible implementation, a distance between one end that is of the heat conductor and that is close to the circuit board and the circuit board is less than a minimum distance between one end that is of the heating element and that faces the substrate and the circuit board.

In this way, a bottom end of the heat conductor is lower than a top end of the heating element. For example, the heat conductor extends until overlapping the heating element in a height direction, so that each part of the heating element can be closer to the heat conductor, and the heat of the heating element is more easily transferred to the heat conductor.

In a possible implementation, the heat dissipation apparatus further includes a thermally conductive potting compound, where the thermally conductive potting compound is disposed on at least the one surface that is of the substrate and that faces the circuit board, the heat conductor is located inside the thermally conductive potting compound, and the heating element at least partially extends into the thermally conductive potting compound.

The thermally conductive potting compound with relatively small thermal resistance is disposed on the substrate, so that thermal resistance from the heating element to the substrate can be reduced, thereby improving the heat dissipation efficiency of the heat dissipation apparatus. In addition, the thermally conductive potting compound has no special requirement on a size and a shape of the heating element and has relatively strong compatibility and a relatively wide application range.

In a possible implementation, a thermal conductivity of the heat conductor is greater than a thermal conductivity of the thermally conductive potting compound.

Because the thermal conductivity of the heat conductor is greater than the thermal conductivity of the thermally conductive potting compound, a heat dissipation channel with relatively small thermal resistance is formed between the heating element or a vicinity of the heating element and the substrate, facilitating rapid heat transfer. In other words, in a process of transferring heat from the heating element to the substrate, the heat is actually more prone to be transferred to the substrate by using the heat conductor with the larger thermal conductivity.

In a possible implementation, there is a distance between the circuit board and one surface that is of the thermally conductive potting compound and that faces the circuit board, or the thermally conductive potting compound fills space between the circuit board and the substrate.

A distance exists between the circuit board and the one surface that is of the thermally conductive potting compound and that faces the circuit board, so that a weight of the heat dissipation apparatus can be minimized without affecting the heat dissipation efficiency. In addition, the thermally conductive potting compound fills the space between the circuit board and the substrate to connect the circuit board to the heat dissipation apparatus, thereby enabling relatively high mechanical strength.

In a possible implementation, an extending direction of the heat conductor is perpendicular to the circuit board.

In this way, the thermal conductive channel formed by the heat conductor may be perpendicular to the circuit board, so that a thermal conductive transmission path is shortest, and the heat dissipation efficiency of the heat dissipation apparatus is improved.

In a possible implementation, the heat conductor is at least one of a thermal conductive sheet, a thermal conductive plate, a thermal conductive pillar, a thermal conductive root system, or a thermal conductive wire made of a high-thermal-conductivity material.

In this way, the heat conductor may be disposed between the heating elements without affecting normal operation of the heating elements.

In a possible implementation, the thermal conductive wire is a flexible thermal conductive wire; or there are at least two heat conductors, and the at least two heat conductors are disposed in an intersecting manner; or the thermal conductive wire is a flexible thermal conductive wire, there are at least two heat conductors, and the at least two heat conductors are disposed in an intersecting manner.

A plurality of heat conductors may be disposed in an intersecting manner, to meet a spatial arrangement requirement on different heating elements.

In a possible implementation, a cross-sectional shape of the heat conductor is a square, a circle, or an oval.

The cross-sectional shape of the heat conductor may be flexibly selected based on space, a distance, or the like between different heating elements.

In a possible implementation, the heat conductor and the substrate are bonded and connected by using a thermal interface material; or the heat conductor and the substrate are integrally formed.

When the heat conductor and the substrate are separately formed, the heat conductor and the substrate are bonded and connected by using the thermal interface material, to avoid reduction in heat transfer efficiency that is caused by a gap between the heat conductor and the substrate. Alternatively, to prevent heat transfer efficiency between the heat conductor and the substrate from being affected, the heat conductor and the substrate may be integrally formed.

In a possible implementation, the at least one heat conductor reaches contact with a side surface or an end surface of the heating element.

The heat conductor is in direct contact with the heating element, to improve heat transfer efficiency between the heat conductor and the heating element.

In a possible implementation, there are a plurality of heat conductors, and heights of the plurality of heat conductors are the same.

Such arrangement makes a heating body easy to process.

In a possible implementation, an insulating layer is disposed on a surface of the heat conductor.

Such arrangement can avoid a short circuit after the heat conductor reaches contact with the heating element or a wire on the circuit board.

In a possible implementation, a plurality of heat dissipation fins are disposed on one surface that is of the substrate and that faces away from the heat conductor.

This facilitates better heat dissipation from the substrate into an ambient environment.

In a possible implementation, the heat dissipation apparatus further includes a side plate, where the side plate and the substrate form a cover body through enclosure, and the cover body covers the heating element on the circuit board.

This facilitates sealant potting between the substrate and the circuit board, and helps the entire heat dissipation apparatus and the circuit board form a whole.

A second aspect of this application, said second aspect not being covered by the claimed invention, provides a heat dissipation apparatus, including a substrate, where at least one heat conductor is disposed on one surface of the substrate, one end of the heat conductor is connected to the substrate, and the other end of the heat conductor extends in a direction away from the substrate.

At least one heat conductor is disposed on the one surface of the substrate, and the other end of the heat conductor extends in the direction away from the substrate. Therefore, when the heat dissipation apparatus is applied to perform heat dissipation on a circuit board, the heat conductor is made extend in a direction in which the circuit board is provided with heating elements. Heat of each heating element, for example, a heating element relatively far away from the substrate, can be rapidly transferred to the substrate by using the heat conductor with relatively small thermal resistance, and then is dissipated from the substrate into an external environment. This effectively reduces thermal conduction resistance from the heating element to the substrate, and improves heat dissipation efficiency of the heat dissipation apparatus.

In a possible implementation, a heat insulation layer is disposed on the heat conductor.

The heat insulation layer is disposed on the heat conductor, so that when the heat dissipation apparatus is applied to the circuit board to perform heat dissipation on the heating element, heat radiated from the heating element to a vicinity can be blocked by the heat insulation layer, thereby improving a heat insulation effect of the heat conductor.

In a possible implementation, the heat conductor is an annular heat conductor, or there are a plurality of heat conductors, and the plurality of heat conductors are spaced and form an annular structure through enclosure.

The annular heat conductor is disposed by enclosing an outer side of some heating elements, so that a heat insulation barrier can be formed around the heating elements. In one aspect, heat of the heating elements is more easily transferred to the substrate by using the heat conductor, and in another aspect, the heat of the heating elements is better prevented from being radiated to a heating element around the heating elements.

In a possible implementation, the heat dissipation apparatus further includes a thermally conductive potting compound, where the thermally conductive potting compound is disposed on the substrate, and the heat conductor is located inside the thermally conductive potting compound.

The thermally conductive potting compound with relatively small thermal resistance is disposed on the substrate, so that when the heat dissipation apparatus is applied to the circuit board to perform heat dissipation on the heating element, thermal resistance from the heating element to the substrate can be reduced, thereby improving the heat dissipation efficiency of the heat dissipation apparatus. In addition, the thermally conductive potting compound has no special requirement on a size and a shape of the heating element and has relatively strong compatibility and a relatively wide application range.

In a possible implementation, a thermal conductivity of the heat conductor is greater than a thermal conductivity of the thermally conductive potting compound.

Because the thermal conductivity of the heat conductor is greater than the thermal conductivity of the thermally conductive potting compound, when the heat dissipation apparatus is applied to the circuit board to perform heat dissipation on the heating element, a heat dissipation channel with relatively small thermal resistance is formed between the heating element or a vicinity of the heating element and the substrate, facilitating rapid heat transfer. In other words, in a process of transferring heat from the heating element to the substrate, the heat is actually more prone to be transferred to the substrate by using the heat conductor with the larger thermal conductivity.

In a possible implementation, an extending direction of the heat conductor is perpendicular to the substrate.

In this way, the thermal conductive channel formed by the heat conductor may be perpendicular to the circuit board, so that a thermal conductive transmission path is shortest, and the heat dissipation efficiency of the heat dissipation apparatus is improved.

In a possible implementation, the heat conductor is at least one of a thermal conductive sheet, a heat dissipation plate, a heat dissipation pillar, a thermal conductive root system, or a heat dissipation wire made of a high-thermal-conductivity material.

In this way, the heat conductor may be disposed between the heating elements without affecting normal operation of the heating elements.

In a possible implementation, the thermal conductive wire is a flexible thermal conductive wire; or there are at least two heat conductors, and the at least two heat conductors are disposed in an intersecting manner; or the thermal conductive wire is a flexible thermal conductive wire, there are at least two heat conductors, and the at least two heat conductors are disposed in an intersecting manner.

A plurality of heat conductors may be disposed in an intersecting manner, to meet a spatial arrangement requirement on different heating elements.

In a possible implementation, a cross-sectional shape of the heat conductor is a square, a circle, or an oval.

The cross-sectional shape of the heat conductor may be flexibly selected based on space, a distance, or the like between different heating elements.

In a possible implementation, the heat conductor and the substrate are bonded and connected by using a thermal interface material; or the heat conductor and the substrate are integrally formed.

When the heat conductor and the substrate are separately formed, the heat conductor and the substrate are bonded and connected by using the thermal interface material, to avoid reduction in heat transfer efficiency that is caused by a gap between the heat conductor and the substrate. Alternatively, to prevent heat transfer efficiency between the heat conductor and the substrate from being affected, the heat conductor and the substrate may be integrally formed.

In a possible implementation, there are a plurality of heat conductors, and heights of the plurality of heat conductors are the same.

Such arrangement makes a heating body easy to process.

In a possible implementation, an insulating layer is disposed on a surface of the heat conductor.

Such arrangement can avoid a short circuit after the heat conductor reaches contact with the heating element or a wire on the circuit board.

In a possible implementation, a plurality of heat dissipation fins are disposed on one surface that is of the substrate and that faces away from the heat conductor.

This facilitates better heat dissipation from the substrate into an ambient environment.

In a possible implementation, the heat dissipation apparatus further includes a side plate, where the side plate and the substrate form a cover body through enclosure.

This facilitates sealant potting on the substrate.

A third aspect of embodiments of this application provides a circuit board assembly, including a circuit board provided with a plurality of heating elements and the foregoing heat dissipation apparatus, where the heat dissipation apparatus is disposed on one surface that is of the circuit board and that is provided with the heating elements.

In this way, heat of each heating element, for example, a heating element relatively far away from the substrate, can be rapidly transferred to the substrate by using the heat conductor with relatively small thermal resistance, and then is dissipated from the substrate into an external environment. This effectively reduces thermal conduction resistance from the heating element to the substrate, and improves heat dissipation efficiency of each component in the circuit board assembly.

According to the invention, one end of at least one heat conductor extends between a high-temperature element and a low-temperature element that are adjacent in the heating elements, to isolate the high-temperature element from the low-temperature element by using the heat conductor.

Temperature partitioning can be implemented by isolating the high-temperature element from the low-temperature element by using the heat conductor, to ensure a low-temperature application environment of the low-temperature element, thereby avoiding over-temperature caused by baking the low-temperature device by the high-temperature device.

In a possible implementation, the circuit board is a double-sided board, and a heat dissipation apparatus is disposed on each of front and back surfaces of the circuit board.

In this way, when the circuit board is a double-sided board, and the front and back surfaces each are provided with heating elements, the heating elements each can perform heat dissipation on the circuit board.

A fourth aspect of embodiments, said fourth aspect not being covered by the claimed invention, of this application provides an electronic device, including a housing and the foregoing circuit board assembly, where the circuit board assembly is disposed inside the housing.

In this way, in the electronic device, heat of each heating element, especially a heating element relatively far away from the substrate, can be rapidly transferred to the substrate by using the heat conductor with relatively small thermal resistance, and then is dissipated into an external environment from the substrate. This effectively reduces thermal conduction resistance from the heating element to the substrate, and improves heat dissipation efficiency of each component in the electronic device.

### BRIEF DESCRIPTION OF DRAWINGS

FIG. 1 is a schematic diagram of a structure of a heat dissipation apparatus in a conventional technology;
FIG. 2 is a schematic diagram of a cross-sectional structure of a heat dissipation apparatus according to Embodiment 1 of this application;
FIG. 3 is a schematic diagram of a cross-sectional structure of another structure of a heat dissipation apparatus according to Embodiment 1 of this application;
FIG. 3a is a schematic diagram of a cross-sectional structure of another structure of a heat dissipation apparatus according to Embodiment 1 of this application;
FIG. 3b is a schematic diagram of a cross-sectional structure of another structure of a heat dissipation apparatus according to Embodiment 1 of this application;
FIG. 3c is a schematic diagram of a cross-sectional structure of another structure of a heat dissipation apparatus according to Embodiment 1 of this application;
FIG. 3d is a schematic diagram of a cross-sectional structure of another structure of a heat dissipation apparatus according to Embodiment 1 of this application;
FIG. 3e is a schematic diagram of a cross-sectional structure of another structure of a heat dissipation apparatus according to Embodiment 1 of this application;
FIG. 4 is a transversal cross-sectional view of still another structure of a heat dissipation apparatus according to Embodiment 1 of this application;
FIG. 5 is a transversal cross-sectional view of still another structure of a heat dissipation apparatus according to Embodiment 1 of this application;
FIG. 6 is a schematic diagram of a cross-sectional structure of still another structure of a heat dissipation apparatus according to Embodiment 1 of this application;
FIG. 7 is a transversal cross-sectional view of the heat dissipation apparatus in FIG. 6;
FIG. 8 is a schematic diagram of a cross-sectional structure of still another structure of a heat dissipation apparatus according to Embodiment 1 of this application;
FIG. 9 is a schematic diagram of a cross-sectional structure of still another structure of a heat dissipation apparatus according to Embodiment 1 of this application;
FIG. 10 is a schematic diagram of a cross-sectional structure of still another structure of a heat dissipation apparatus according to Embodiment 1 of this application;
FIG. 11 is a schematic diagram of a cross-sectional structure of still another structure of a heat dissipation apparatus according to Embodiment 1 of this application;
FIG. 12 is a schematic diagram of a cross-sectional structure of still another structure of a heat dissipation apparatus according to Embodiment 1 of this application;
FIG. 13 is a schematic cross-sectional view of a circuit board assembly according to Embodiment 2 of this application;
FIG. 14 is a schematic cross-sectional view of another structure of a circuit board assembly according to Embodiment 2 of this application;
FIG. 15 is a schematic cross-sectional view of another structure of a circuit board assembly according to Embodiment 2 of this application; and
FIG. 16 is a schematic diagram of a structure of an electronic device according to Embodiment 3 of this application.

### Description of reference numerals:

100: heat dissipation apparatus; 10: circuit board; 11: output common mode inductor; 12: capacitor; 13: power factor correction input inductor; 14: capacitor for suppressing electromagnetic interference of a power supply; 20, 21, and 22: heating elements; 23, 23a, and 23b: high-temperature elements; 24, 24a, and 24b: low-temperature elements; 30: substrate; 30': step portion; 31: heat dissipation fin; 50, 501, 502, 503, 504, 505, and 506: heat conductors; 50a: primary heat conductor; 50b: branch heat conductor; 50c: sub-heat conductor; 51: heat insulation layer; 52: thermally conductive potting compound; 53: side plate; 54: annular heat conductor; 55: thermal interface material; 81: circuit board; 82: heat sink; 83: small to-be-cooled device; 85: to-be-cooled device; 200: circuit board assembly; 300: electronic device; and 301: housing.

### DESCRIPTION OF EMBODIMENTS

Terms used in implementations of this application are merely used to explain specific embodiments of this application, but are not intended to limit this application. The following describes in detail implementations of embodiments of this application with reference to the accompanying drawings.

With the advent of the era of high-speed communication, a quantity of end sites increases sharply, and proportions of quantities of pole sites and small sites also keep increasing. To implement high-power power supply in 4G, 5G, and 6G pole sites, a higher requirement is imposed on heat dissipation performance of blade power supplies that use natural heat dissipation. This application is proposed to improve heat dissipation efficiency of a heat dissipation apparatus. It should be understood that, in addition to a blade power supply, the heat dissipation apparatus provided in this application is also applicable to another electronic device having a circuit board assembly.

### Embodiment 1

Refer to FIG. 2. A circuit board assembly provided in this embodiment comprises a circuit board 10 and a heat dissipation apparatus 100. A plurality of heating elements 20 are disposed on the circuit board 10.

Circuit boards may be classified into a single-sided board, a double-sided board, a multi-sided board, and the like based on a quantity of layers. In a description of this embodiment, an example in which the circuit board 10 is a single-sided board is used for description. Cases of the double-sided board and the multi-sided board are similar to that of the single-sided board, and details are not repeated in this embodiment.

The heating elements 20 refer to electronic components disposed on the circuit board, for example, an output inductor and a capacitor. Sizes and specifications of the heating elements on the circuit board 10 vary with different types. In this embodiment, an example in which the heating elements 20 include a heating element 21 (for example, relatively close to a substrate) with a relatively large size and a heating element 22 (for example, relatively far away from the substrate) with a relatively small size is used for description. Refer to FIG. 2. The heating element 21 and the heating element 22 continuously generate heat during normal operation. To ensure normal operation of the circuit board 10, the heat dissipation apparatus 100 provided in this embodiment performs heat dissipation on the heating element 21 and the heating element 22.

To perform heat dissipation on the heating elements 20, the heat dissipation apparatus 100 includes a substrate 30. The substrate 30 is disposed opposite to one surface that is of the circuit board 10 and that is provided with the heating elements 20. In addition, to rapidly transfer heat on the heating elements 20 to the substrate 30, one or more heat conductors 50 are disposed on one surface that is of the substrate 30 and that faces the circuit board 10. The heat conductor 50 extends toward the circuit board 10 and is close to the heating elements 20. According to the invention, one end of the heat conductor 50 is connected to the substrate 30, and the other end extends toward the circuit board 10 and is close to the heating elements 20.

It can be understood that a part of the heat of the heating elements 22 is dissipated into the air, and is transferred to the substrate 30 from the air. However, because a top end of the heating element 22 with a relatively small size is relatively far away from the substrate 30, thermal resistance is relatively large. Therefore, very little heat is transferred in this manner. Most of the heat of the heating element 22 is transferred to the substrate 30 by using the heat conductor 50 around the heating element 22. This is because the heat conductor 50 around the heating element 22 has relatively small thermal resistance. This is equivalent to forming a heat transfer channel with relatively small thermal resistance around the substrate 30 and the heating element 22. Therefore, most heat of the heating element 22 is rapidly transferred to the substrate 30 by using the heat conductor 50 around the heating element 22, and then is dissipated into an external environment from the substrate 30. This effectively reduces thermal conduction resistance from the heating element and the substrate 30, and improves heat dissipation efficiency of the heat dissipation apparatus 100.

In addition, a small part of the heat of the heating element 21 is dissipated into the air and then is transferred to the substrate 30 from the air. Most heat is transferred to the substrate 30 by using the heat conductor 50 around the heating element 21, and finally is dissipated into the external environment from the substrate 30. It can be understood that, a case of the heating element 20 with another size is similar to this case. Because the heat conductor 50 with relatively small thermal resistance is disposed at a vicinity of the heating element 20, a thermal conductive channel with relatively small thermal resistance is formed between the heating element 20 and the substrate 30, to rapidly transfer most heat of the heating element 20 to the substrate 30, thereby improving the heat dissipation efficiency of the heat dissipation apparatus 100.

In a possible implementation, a distance H1 between the circuit board 10 and the one end that is of the heat conductor 50 and that is close to the circuit board 10 is less than a minimum distance H2 between one end that is of the heating element and that faces the substrate 30 and the circuit board 10. This ensures that one end of the heat conductor 50 extends to be close to a lowest heating element 22, to ensure that heat generated by the lowest heating element 22 can be conducted outward by using the heat conductor 50 in time. As described above, heights of the heating elements 20 on the circuit board 10 are different. Therefore, when it is ensured that a distance H2 between the circuit board 10 and a top of the lowest heating element 20, for example, the heating element 22 is greater than a distance H1 between a bottom end of the heat conductor 50 and the circuit board 10, a distance between a top of a relatively high heating element 20 and the circuit board 10 is greater than the distance H1 between the bottom end of the heat conductor 50 and the circuit board 10. In this way, the heat conductor 50 can perform thermal conduction on both a relatively high heating element 20 and a relatively low heating element 20. In this embodiment of this application, it should be noted that the distance H1 between the circuit board 10 and one end of the heat conductor 50 that faces the circuit board 10 may be 0. For example, the one end that is of the heat conductor 50 and that faces the circuit board 10 abuts against the circuit board 10.

It should be understood that, the bottom end of the heat conductor 50 can be lower than a top end of the heating element 20. For example, the heat conductor 50 extends until overlapping the heating element 20 in a height direction, so that each part of the heating element 20 can be closer to the heat conductor 50, and the heat of the heating element 20 is more easily transferred to the heat conductor 50.

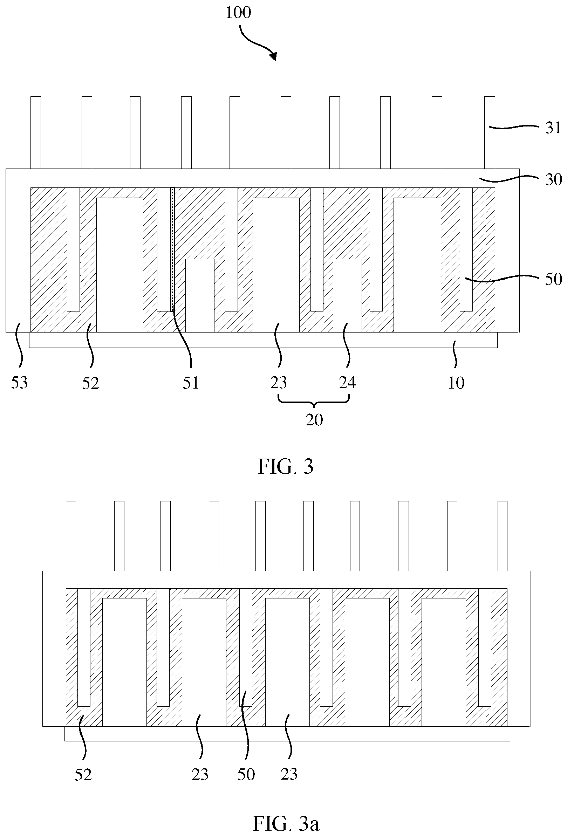

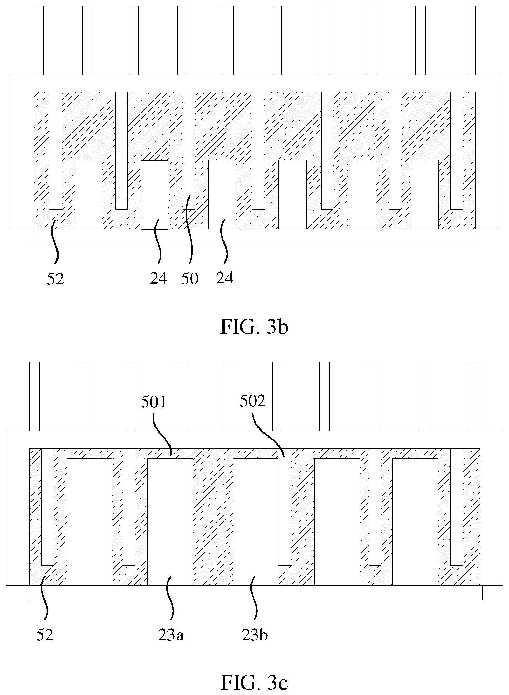

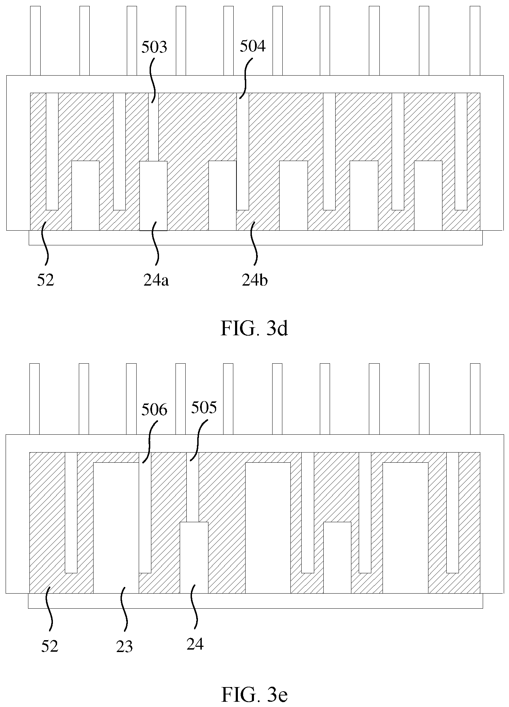

In this embodiment of this application, the heating elements 20 include a plurality of types of components with different specifications, including a high-temperature element with a relatively high rated operating temperature and a low-temperature element with a relatively low rated operating temperature. "High temperature" and "low temperature" refer to that a preset value may be specified in advance as required. A heating element 20 whose rated operating temperature is higher than the preset value is referred to as a high-temperature element, and a heating element 20 whose rated operating temperature is lower than the preset value is referred to as a low-temperature element. For example, in five heating elements 20 shown in FIG. 3, three relatively high heating elements 20 are high-temperature elements 23 and two relatively low heating elements 20 are low-temperature elements 24. It should be understood that, the description herein is only an example, and there is no correspondence between a size of the heating element 20 and a rated operating temperature thereof. In a specific working process, alternatively, the three relatively high heating elements 20 may be low-temperature elements 24, and the two relatively low heating elements are high-temperature elements 23.

Both a high-temperature element 23 and a low-temperature element 24 are disposed on the circuit board 10. If the high-temperature element 23 is adjacent to the low-temperature element 24, the low-temperature element 24 encounters a problem of over-temperature caused by baking the low-temperature element 24 by the high-temperature element 23. To resolve the problem, one end of at least one heat conductor 50 extends between the high-temperature element 23 and the low-temperature element 24 that are adjacent in the heating elements, to isolate the high-temperature element 23 from the low-temperature element 24 by using the heat conductor 50. It can be understood that, some heat conductors 50 each is disposed between the high-temperature element 23 and the low-temperature element 24 that are adjacent, so that temperature partitioning can be implemented between a high temperature and a low temperature. In this way, a low-temperature application environment of the low-temperature element 24 can be ensured, thereby avoiding over-temperature caused by baking the low-temperature device by the high-temperature device. For example, one ends of at least some heat conductors 50 may extend to the circuit board 10. Alternatively, as shown in the figures, there is a distance between one end of the heat conductor 50 and the circuit board 10.

When the high-temperature elements 23 and the low-temperature elements 24 are sequentially spaced as shown in FIG. 3, the heat conductors 50 may be arranged between the high-temperature elements 23 and the low-temperature elements 24 that are adjacent. When the high-temperature elements 23 and the low-temperature elements 24 are arranged randomly, it is necessary to dispose the heat conductors 50 between at least some or all of the high-temperature elements 23 and the low-temperature elements 24 that are arranged adjacently.

It should be understood that, a position for disposing the heat conductor 50 includes, but is not limited to, a position between the high-temperature element 23 and the low-temperature element 24 shown in FIG. 3. Refer to FIG. 3a. The heat conductor 50 may alternatively be disposed between the high-temperature elements 23, and the heat conductor 50 isolates the high-temperature elements 23. Alternatively, as shown in FIG. 3b, the heat conductor 50 may be disposed between the low-temperature elements 24, and the heat conductor 50 isolates the low-temperature elements 24. In this way, the low-temperature element 24 is not easily affected by ambient heat.

In some other examples, the heat conductor 50 may alternatively be disposed at another position. For example, as shown in FIG. 3c, a heat conductor 501 is not disposed between adjacent heating elements, but extends to a top of a high-temperature element 23a. A heat conductor 502 may further reach contact with one side surface of a high-temperature element 23b, provided that insulation performance is ensured. Alternatively, as shown in FIG. 3d, a heat conductor 503 is not disposed between adjacent heating elements, but extends to a top of a low-temperature element 24a. A heat conductor 504 may further reach contact with one side surface of a low-temperature element 24b, provided that insulation performance is ensured. Alternatively, as shown in FIG. 3e, a heat conductor 505 is not disposed between adjacent heating elements, but extends to a top of a low-temperature element 24. A heat conductor 506 may further reach contact with one side surface of a high-temperature element 23, provided that insulation performance is ensured.

According to the invention, to further implement partitioning and isolation between the high-temperature element 23 and the low-temperature element 24, a heat insulation layer 51 is disposed on the heat conductor 50 between the high-temperature element 23 and the low-temperature element 24. The heat insulation layer 51 faces the low-temperature element 24. It can be understood that, the heat insulation layer 51 is disposed on one side that is of the heat conductor 50 and that is close to the low-temperature element 24, so that heat radiated from the high-temperature element 23 to the low-temperature element 24 can be blocked by the heat insulation layer 51, thereby improving a temperature insulation effect of the heat conductor 50. During specific arrangement, the heat insulation layers 51 may be disposed on all the heat conductors 50 between the high-temperature elements 23 and the low-temperature elements 24, or the heat insulation layers 51 may be disposed on at least some heat conductors 50 between the high-temperature elements 23 and the low-temperature elements 24.

In this embodiment of this application, to further improve the heat dissipation efficiency of the heat dissipation apparatus 100, the heat dissipation apparatus 100 may further include a thermally conductive potting compound 52. The thermally conductive potting compound 52 is, for example, potting adhesive, which is used for bonding, sealing, and potting electronic elements. Before curing, the potting adhesive is liquid and has fluidity. After complete curing, the potting adhesive can provide functions of waterproof, moisture-proof, dustproof, insulation, thermal conduction, sealing, corrosion resistance, temperature resistance, and shockproof. There are a plurality of types of potting adhesive, which can be classified into epoxy potting adhesive, organic silicone potting adhesive, polyurethane potting adhesive, and the like based on a type of a material. For example, in this application, the thermally conductive potting compound 52 may be any one of the foregoing types.

In the example shown in FIG. 3, the thermally conductive potting compound 52 is disposed on at least the one surface that is of the substrate 30 and that faces the circuit board 10, the heat conductor 50 is located inside the thermally conductive potting compound 52, and the heating element 20 at least partially extends into the thermally conductive potting compound 52. In this way, the thermally conductive potting compound 52 with relatively small thermal resistance is disposed on the substrate 30, so that thermal resistance from the heating element to the substrate 30 can be reduced, thereby improving the heat dissipation efficiency of the heat dissipation apparatus 100. In addition, the thermally conductive potting compound 52 in a liquid state fills space between the substrate 30 and the circuit board 10, and automatically covers an outer contour of the heating element 20 during filling. Therefore, the thermally conductive potting compound 52 has no special requirement on a size and a shape of the heating element 20 and has relatively strong compatibility and a relatively wide application range.

In this embodiment of this application, a thermal conductivity of the heat conductor 50 may be made greater than a thermal conductivity of the thermally conductive potting compound 52. Because the thermally conductive potting compound 52 covers the heat conductor 50, a plurality of heat dissipation channels with a relatively large thermal conductivity can be formed between the heating element 20 or a vicinity of the heating element 20 and the substrate 30. In a process of transferring heat from the heating element 20 to the substrate 30, the heat is actually more prone to be transferred to the substrate 30 by using the heat conductor 50 with relatively small thermal resistance.

When the heat dissipation apparatus 100 further includes the thermally conductive potting compound 52, the heat dissipation apparatus 100 is relatively heavy. To avoid this case, a distance may be enabled between the circuit board 10 and one surface that is of the thermally conductive potting compound 52 and that faces the circuit board 10. In some other examples, the thermally conductive potting compound 52 fills the entire space between the circuit board 10 and the substrate 30. For example, the thermally conductive potting compound 52 fills the entire space between the circuit board 10 and the substrate 30, so that after the circuit board 10 is connected to the heat dissipation apparatus 100, mechanical strength is relatively high and rapid thermal conduction can be implemented for the circuit board 10.

To facilitate potting by using the thermally conductive potting compound 52, the heat dissipation apparatus 100 may further include a side plate 53. The side plate 53 and the substrate 30 together form a cover body through enclosure, and the cover body covers the heating element 20 on the circuit board 10. This facilitates compound potting between the substrate 30 and the circuit board 10, and helps the entire heat dissipation apparatus 100 and the circuit board 10 form a whole. The heat dissipation apparatus 100 shown in FIG. 3 is used as an example for description. When the heat conductor 50 is disposed on the substrate 30, liquid potting adhesive is injected into the cover body, then the circuit board 10 provided with the heating element 20 is inversely inserted into the cover body, and the circuit board 10 is carried on an end edge of the side plate 53. After the potting adhesive is cured, a potting process of the thermally conductive potting compound 52 is completed. In this application, the potting process of the thermally conductive potting compound 52 includes, but is not limited to, the above-described manner. If no side plate 53 is provided, the substrate 30 may be first fixed above the heating element by using another jig or the like, and then the potting adhesive fills the space between the substrate 30 and the circuit board 10.

In this embodiment of this application, an extending direction of the heat conductor 50 may be perpendicular to the circuit board 10. In this way, the thermal conductive channel formed by the heat conductor 50 may be perpendicular to the circuit board 10, so that a thermal conductive transmission path is shortest, and the heat dissipation efficiency of the heat dissipation apparatus 100 is improved. Certainly, the extending direction of the heat conductor includes, but is not limited to, an extending direction perpendicular to the circuit board 10. For example, the extending direction of the heat conductor 50 may alternatively form an inclined angle with the circuit board 10. For example, at least some heat conductors around the high temperature-element may be inclined toward the high-temperature element, so that a heat dissipation effect of the high-temperature element is better.

It should be understood that, in FIG. 3, the heating element 20 does not reach contact with the heat conductor 50, but is spaced apart from the heat conductor 50. Because gaps between the heating elements 20 are not uniform, there is a correspondence between a position for disposing the heat conductor 50 on the substrate 30 and a position for disposing the heating element 20 on the circuit board 10. Therefore, before potting by using the thermally conductive potting compound 52, a position of the substrate 30 needs to be aligned with that of the circuit board 10, to avoid mutual interference between the heat conductor 50 and the heating element 20.

It should be understood that, there is also a correspondence between a height for disposing the heat conductor 50 on the substrate 30 and a height for disposing the heating element 20 on the circuit board 10. For example, a height of a heat conductor 50 near a relatively high heating element 20 is relatively large, and a height of a heat conductor 50 near a relatively low heating element 20 is relatively small.

In a possible implementation, to facilitate processing of the heat conductor 50, when there are a plurality of heat conductors 50, heights of the plurality of heat conductors 50 may be made the same. Certainly, in other examples, the heights of the plurality of heat conductors 50 may alternatively be different.

In this embodiment of this application, to further improve the heat dissipation efficiency of the heat dissipation apparatus 100, a plurality of heat dissipation fins 31 may be disposed on one surface that is of the substrate 30 and that faces away from the heat conductor 50. In this way, heat on the substrate 30 may also be better dissipated into an ambient environment by using the heat dissipation fins 31. It should be understood that, in some cases, alternatively, no heat dissipation fin may be disposed. For example, when an overall size of the heat dissipation apparatus is relatively small, or when mounting space is relatively small, no heat dissipation fin may be disposed on the one surface that is of the substrate 30 and that faces away from the heat conductor 50.

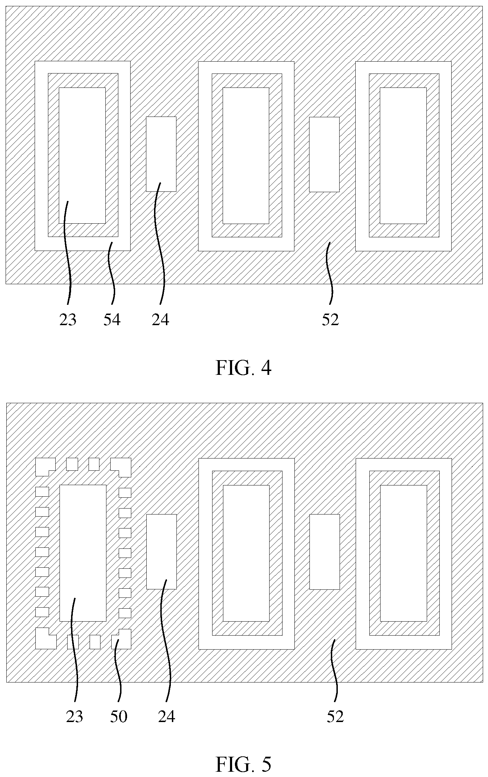

In this embodiment of this application, when disposed between the high-temperature element 23 and the low-temperature element 24 that are adjacent, the heat conductor 50 can provide a function of partitioning between a high temperature and a low temperature. To make a partitioning effect more obvious, with reference to FIG. 4, in a possible implementation, the heat conductor 50 is an annular heat conductor 54, and the annular heat conductor 54 is disposed by enclosing an outer side of the high-temperature element 23 adjacent to the low-temperature element 24. When the annular heat conductor 54 is disposed around the high-temperature element 23, heat of the high-temperature element 23 can be more easily transferred to the substrate 30 by using the annular heat conductor 54. In addition, when more heat is transferred to the substrate 30 by using the annular heat conductor 54, the heat transferred to low-temperature element 24 is reduced accordingly.

It should be understood that "the annular heat conductor" means that an outer contour of a cross section of the heat conductor in a direction parallel to the substrate 30 is substantially annular, and may include a structure of a square ring, a circular ring, a polygonal ring, or an irregular ring. The annular structure may not be a continuous structure, for example, may be an intermittent structure or a discontinuous structure, provided that the annular structure has an approximately annular shape. In addition, the annular heat conductor 54 may surround the high-temperature element 23 or the low-temperature element 24.

In this embodiment of this application, the heat conductor 50 may be in a plate shape, to better isolate the high-temperature element 23 from the low-temperature element 24. In some examples, if the heat conductor 50 is in the plate shape and is an annular heat conductor, the entire annular heat conductor 54 may be formed into a cylindrical shape or a square tubular shape.

In some other examples, refer to FIG. 5. A plurality of spaced heat conductors 50 are disposed on an outer side of the high-temperature element 23 adjacent to the low-temperature element 24. In this example, the heat conductor 50 may be formed into a plate shape or may be formed in a pillar shape. For example, a plurality of spaced heat conductors 50 may alternatively be disposed by enclosing the outer side of the high-temperature element 23, to form a heat insulation barrier around the high-temperature element 23.

In this embodiment of this application, when there are a plurality of heat conductors 50, the plurality of heat conductors 50 are at least one of thermal conductive sheets, thermal conductive plates, thermal conductive pillars, thermal conductive root systems, or thermal conductive wires made of high-thermal-conductivity materials. A thermal conductive pillar with a relatively small diameter may be considered as a needle-shaped heat dissipation needle.

For example, when the plurality of heat conductors 50 are formed with a same structure, all the plurality of heat conductors 50 are thermal conductive sheets; or all the plurality of heat conductors 50 are thermal conductive plates; or all the plurality of heat conductors 50 are thermal conductive pillars; or all the plurality of heat conductors 50 are thermal conductive wires; or all the plurality of heat conductors 50 are thermal conductive root systems.

In some other examples, the plurality of heat conductors 50 include two structural forms. For example, the plurality of heat conductors 50 include a thermal conductive sheet and a thermal conductive plate; or the plurality of heat conductors 50 include a thermal conductive sheet and a thermal conductive pillar; or the plurality of heat conductors 50 include a thermal conductive sheet and a thermal conductive wire; or the plurality of heat conductors 50 include a thermal conductive plate and a thermal conductive pillar; or the plurality of heat conductors 50 include a thermal conductive plate and a thermal conductive wire; or the plurality of heat conductors 50 include a thermal conductive pillar and a thermal conductive wire.

In some other examples, the plurality of heat conductors 50 include three structural forms. For example, the plurality of heat conductors 50 include a thermal conductive sheet, a thermal conductive plate, and a thermal conductive pillar; or the plurality of heat conductors 50 include a thermal conductive sheet, a thermal conductive plate, and a thermal conductive wire; or the plurality of heat conductors 50 include a thermal conductive wire, a thermal conductive plate, and a thermal conductive pillar. In some other examples, the plurality of heat conductors 50 include four structural forms. For example, the plurality of heat conductors 50 include a thermal conductive sheet, a thermal conductive plate, a thermal conductive pillar, and a thermal conductive wire.

In this embodiment of this application, a cross-sectional shape of the heat conductor 50 in the direction parallel to the substrate 30 may be a square, a circle, or an oval. In practice, the cross-sectional shape of the heat conductor 50 may be flexibly selected based on space, a distance, or the like between different heating elements. In some other examples, the heat conductor may alternatively be a hollow structure having a cavity inside, or may be formed by two or more materials. It should be noted that, in this embodiment of this application, the cross section may be a cross section of the heat conductor 50 in the direction parallel to the substrate 30.

It should be understood that, in the accompanying drawings of this application, a case that the heat conductor is located between the heating elements is illustrated as an example. An arrangement position of the heat conductor includes this position but is not limited thereto. The heat conductor may further reach contact with a surface of the heating body, for example, may reach contact with a side wall and a top end surface of the heating body.

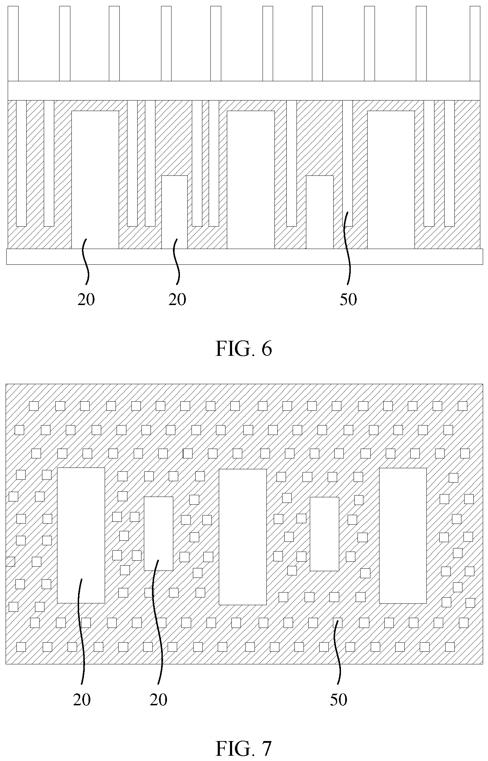

In this embodiment, refer to FIG. 6 and FIG. 7. When the heat conductor 50 is a thermal conductive pillar, an arrangement position of the heat conductor 50 may be flexibly set, and may be set based on an outer contour structure of the heating element 20, a distance between the heating elements, or the like. For example, one or more heat conductors 50 may be disposed between adjacent heating elements 20. Further, the heat conductor 50 may be disposed not only at a position close to the heating element 20, but also at a position relatively far away from the heating element 20, to better perform heat dissipation on the heating element 20.

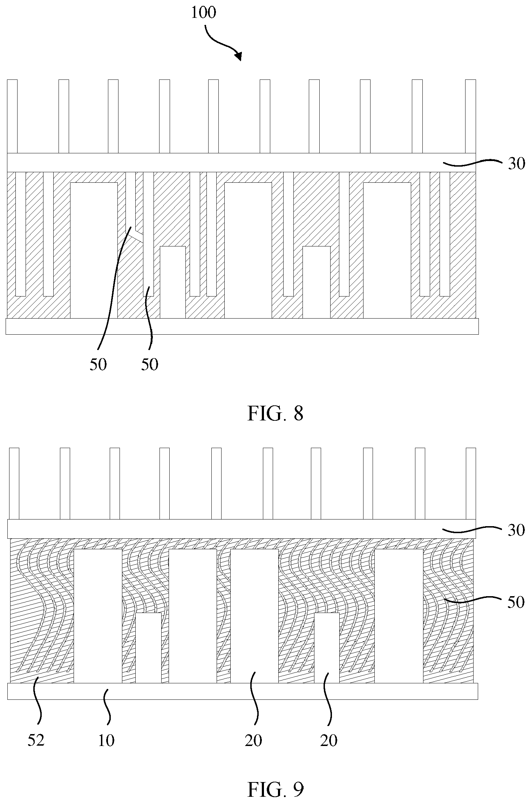

In a possible implementation, at least two heat conductors are disposed in an intersecting manner. In the heat dissipation apparatus 100 shown in FIG. 8, when the heat conductor 50 is a thermal conductive sheet or a thermal conductive plate, adjacent heat conductors 50 may intersect each other. This is conductive to better transferring heat of the heating element to the substrate 30, and can meet a spatial arrangement requirement of different heating elements.

In this embodiment of this application, refer to FIG. 9. When the heat conductor 50 is a thermal conductive wire, compared with the heat conductor 50 in another structural form, distribution density of the heat conductors 50 between the heating elements is relatively large. In addition, there is no specific requirement on a shape of space between the heating elements, achieving a better heat dissipation effect of the heating element 20.

In a possible implementation, the at least one heat conductor 50 reaches contact with a side surface or an end surface of the heating element 20. In this way, the heat conductor 50 reaches direct contact with the heating element 20, so that heat transfer efficiency between the heat conductor 50 and the heating element 20 is higher. For example, when the heat conductors 50 shown in FIG. 9 are thermal conductive wires, the thermal conductive wires are formed into flexible structures. For example, during compound potting, the substrate 30 provided with the thermal conductive wires may be first fixed above the circuit board 10 by using another jig or the like. In addition, the thermal conductive wires are naturally dropped to the heating element 20, so that some thermal conductive wires are suspended between the heating elements 20, and some thermal conductive wires are jacked up by the heating elements 20. In this state, optionally, the thermally conductive potting compound 52 may fill space between the substrate 30 and the heating elements 20. In the example above, the wire-like heat conductor 50 is in a flexible state, and may reach contact with the heating element and be jacked up. In this embodiment of this application, the thermal conductive wire may be a copper wire, an aluminum wire, or another high-thermal-conductivity material. Optionally, copper, aluminum, or another high-thermal-conductivity material may also be used for one of the thermal conductive sheet, the thermal conductive plate, the thermal conductive pillar, and the thermal conductive root system. It can be understood that the thermal conductive wire includes, but is not limited to, a flexible thermal conductive wire or a rigid thermal conductive wire. When the thermal conductive wire is disposed, the thermally conductive potting compound may not be disposed on the substrate. It should be noted that, when the circuit board 10 is a double-sided board, the substrate 30 provided with the thermal conductive wire may be separately fixed above and below the circuit board 10 by using another jig or the like. Certainly, when the heat conductor 50 is a thermal conductive sheet, a thermal conductive plate, a thermal conductive pillar, or a thermal conductive root system, the substrate 30 provided with the heat conductor 50 may also be fixed above or below the circuit board 10 by using a jig or the like, and then compound potting is performed between the substrate 30 and the circuit board 10, so that the heat conductor 50 is located inside the thermally conductive potting compound 52.

In some other examples, to enable more contact between the heat conductor 50 and the heating element 20, a thermal conductive pad or an interface material may be disposed between the heat conductor 50 and the heating element 20. This solution is particularly applicable to a case that no thermally conductive potting compound is disposed between the substrate 30 and the circuit board 10.

In this embodiment of this application, an insulating layer is disposed on a surface of the heat conductor 50. Such arrangement can avoid a short circuit after the heat conductor 50 reaches contact with the heating element or a wire on the circuit board 10. Further, for example, a material with a relatively high thermal conductivity may be selected for the insulating layer, to reduce impact on heat transfer efficiency of the heat conductor 50.

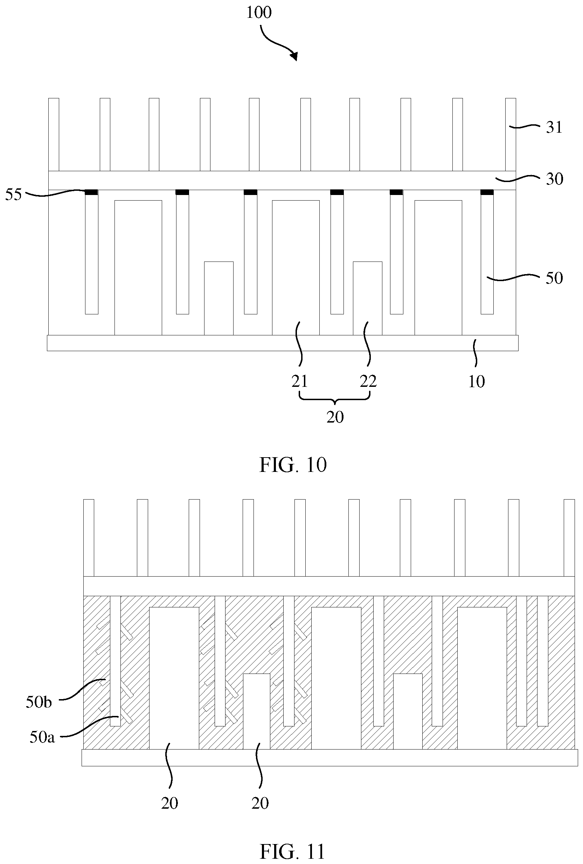

In this embodiment of this application, refer to FIG. 10. The heat conductor 50 and the substrate 30 may be bonded and connected by using a thermal interface material 55. This is because when the heat conductor 50 and the substrate 30 are separately formed, a gap exists between the heat conductor 50 and the substrate 30, resulting in reduction in the heat transfer efficiency. In addition, the heat conductor 50 and the substrate 30 are bonded and connected by using the thermal interface material 55, so that the heat conductor 50 fits with the substrate 30 without a gap, thereby improving the heat transfer efficiency. Further, to improve connection strength between the heat conductor 50 and the substrate 30, the heat conductor 50 and the substrate 30 may further be connected by using screws or the like.

It should be understood that the heat conductor 50 and the substrate 30 may be integrally formed to further improve the heat transfer efficiency between the heat conductor 50 and the substrate 30.

In this embodiment of this application, the heat conductor 50 may be a thermal conductive root system. Compared with the heat conductor 50 in another structural form, when the heat conductor 50 is the thermal conductive root system, the heat conductor 50 may include a primary heat conductor 50a and a plurality of branch heat conductors 50b connected to the primary heat conductor 50a. By disposing a relatively large quantity of branch heat conductors 50b on the primary heat conductor 50a, distribution density of the heat conductors 50 between the heating elements is larger, achieving a better heat dissipation effect on the heating element 20.

For example, in the heat dissipation apparatus shown in FIG. 11, the primary heat body 50a extends from one end of the substrate 30 toward a direction of the circuit board 10, one end of the branch heat conductor 50b is connected to the primary heat conductor 50a, and the other end of the branch heat conductor 50b extends from a side of the primary heat conductor 50a.

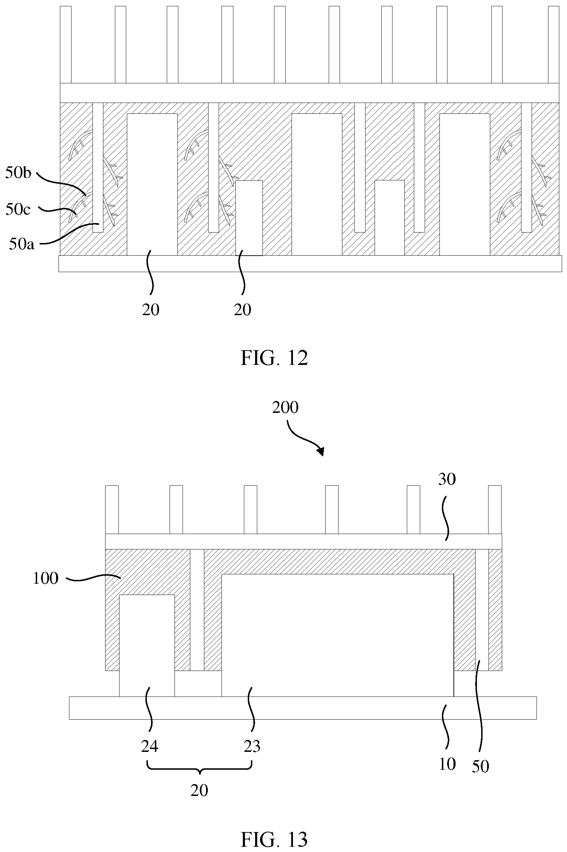

Alternatively, based on the heat dissipation apparatus in FIG. 11, as shown in FIG. 12, the heat conductor 50 includes a primary heat conductor 50a and branch heat conductors 50b, and a plurality of sub-heat conductors 50c extending from sides of the branch heat conductors 50b are connected to the branch heat conductors 50b. In this way, the primary heat conductor 50a, the branch heat conductors 50b, and the sub-heat conductors 50c form a root system structure, so that the heat conductors can conduct more heat outward to achieve a better thermal conduction effect, thereby ensuring that the heat generated by the heating element 20 can be dissipated outward in time by using the structure of the thermal conductive root system, and ensuring that the heat dissipation apparatus has a good heat dissipation effect on the circuit board 10.

It should be understood that, FIG. 11 and FIG. 12 are examples of the thermal conductive root system. In another example, a structure of the thermal conductive root system includes, but is not limited to, the structures including the primary heat conductor 50a, the branch heat conductors 50b, and the sub-heat conductor 50c shown in FIG. 11 and FIG. 12, and another one level of branch structure or another two or more levels of branch structures may be further disposed on the branch heat conductor 50b. For example, a next level of branch heat conductor is further disposed on the branch heat conductor 50c. If space allows, more branch heat conductors make heat dissipation more sufficient. A thermal conductive root system with a mesh-like structure similar to a tree root may be formed between the substrate 30 and the circuit board 10.

To verify the heat dissipation effect of the heat dissipation apparatus 100 in this embodiment, the applicant performs heat comparison experiments on a circuit board provided with a heat dissipation apparatus in a conventional technology and a circuit board provided with the heat dissipation apparatus in this application.

The heat dissipation apparatus in the conventional technology is applied to a circuit board in a blade power supply with a power of A kW (A may be selected based on an actual requirement). A common-mode inductor and a capacitor adjacent to the common-mode inductor may be disposed on the circuit board. A temperature of the common-mode inductor is 114.7°C, and a temperature of the capacitor adjacent to the common-mode inductor is 111.8°C.

The heat dissipation apparatus 100 described in Embodiment 1 of this application is applied to the circuit board in the blade power supply with the power of A kW. Heat conductors are disposed around the common-mode inductor for isolation. In this case, a measured temperature of the common-mode inductor is 109.9°C, which is reduced by 4.8°C compared with that in the conventional technology; and a measured temperature of the capacitor adjacent to the common-mode inductor is 107.2°C, which is reduced by 4.6°C compared with that in the conventional technology. Therefore, it can be learned that the heat dissipation apparatus 100 in Embodiment 1 improves a heat dissipation capability for the circuit board.

The heat dissipation apparatus in the conventional technology is applied to another circuit board in a blade power supply with a power of B kW (A > B). A temperature of a capacitor adjacent to an input inductor is 103.7°C.

The heat dissipation apparatus 100 described in Embodiment 1 of this application is applied to the circuit board in the blade power supply with the power of B kW. The heat conductors 50 are disposed around the input inductor for isolation. A temperature, measured in the test, of the capacitor adjacent to the input inductor is 97.72°C, which is reduced by about 6°C compared with that in the conventional technology. Therefore, it can be learned that the heat dissipation apparatus 100 in Embodiment 1 improves a heat dissipation capability for the circuit board.

### Embodiment 2

This embodiment provides a circuit board assembly. Refer to FIG. 13. A circuit board assembly 200 includes a circuit board 10 provided with a plurality of heating elements 20 and the heat dissipation apparatus 100 described above. The heat dissipation apparatus 100 is disposed on one surface that is of the circuit board 10 and that is provided with heating elements 20. Structures, functions, working principles, and the like of the heat dissipation apparatus 100 have been described in detail in Embodiment 1, and details are not described herein again.

In this embodiment of this application, a plurality of heating elements 20 are disposed on the circuit board 10. To perform heat dissipation on the heating elements 20, the heat dissipation apparatus 100 includes a substrate 30. The substrate 30 is disposed opposite to the one surface that is of the circuit board 10 and that is provided with the heating elements 20. In addition, to rapidly transfer heat of the heating elements to the substrate 30, at least one heat conductor 50 is disposed on one surface that is of the substrate 30 and that faces the circuit board 10. One end of the heat conductor 50 is connected to the substrate 30, and the other end extends toward the circuit board 10 and is close to the heating elements.

In this way, heat of each heating element, especially a heating element with a relatively small size, can be rapidly transferred to the substrate 30 by using the heat conductor 50 with relatively small thermal resistance, and then is dissipated from the substrate 30 into an external environment. This effectively reduces thermal conduction resistance from the heating element to the substrate 30, and improves heat dissipation efficiency of each component in the assembly of the circuit board 10.

In this embodiment of this application, one end of at least one heat conductor 50 extends between a high-temperature element 23 and a low-temperature element 24 that are adjacent in the heating elements, to isolate the high-temperature element 23 from the low-temperature element 24 by using the heat conductor 50. It should be understood that, temperature partitioning can be implemented by isolating the high-temperature element 23 from the low-temperature element 24 by using the heat conductor 50, to ensure a low temperature application environment of the low-temperature element 24, thereby avoiding over-temperature caused by baking the low-temperature device by the high-temperature device.

It can be understood that, alternate distribution of the high-temperature elements and the low-temperature elements is illustrated in the figures in this application. However, distribution of the heating elements includes the alternate distribution but is not limited thereto. Alternatively, some high-temperature elements are distributed in a centralized manner, or some low-temperature elements are distributed in a centralized manner, or some high-temperature elements are adjacent to some low-temperature elements, or a small quantity of low-temperature elements are adjacent to a large quantity of high-temperature elements, or a small quantity of high-temperature elements are adjacent to a large quantity of low-temperature elements. In these cases, provided that one end of at least one heat conductor 50 extends between the high-temperature element 23 and the low-temperature element 24 that are adjacent in the heating elements, an effect of avoiding over-temperature caused by baking the low-temperature device by the high-temperature device can be achieved.

In the example shown in FIG. 13, a connection between the circuit board 10 and the heat dissipation apparatus 100 is described by using an example of a case that the circuit board 10 is a single-sided board. However, the circuit board 10 includes, but is not limited to, a single-sided board, and the circuit board 10 may alternatively be a double-sided board. A heat dissipation apparatus 100 may be disposed on each of front and back surfaces of the circuit board 10. In this way, when the circuit board 10 is a double-sided board, and the front and back surfaces each are provided with heating elements, the two heat dissipation apparatuses 100 each can perform heat dissipation on the circuit board 10.

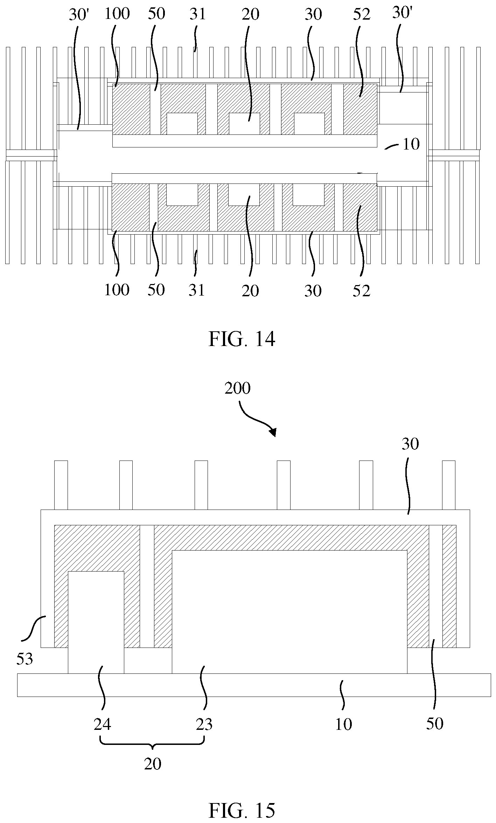

In FIG. 14, the circuit board assembly may include two circuit boards 10 and two heat dissipation apparatuses 100. The two single-sided circuit boards 10 are disposed back to back. To be specific, surfaces of the two circuit boards that are provided with the heating elements 20 are disposed facing away from each other, and surfaces opposite to the surfaces provided with the heating elements are disposed face to face at a specific distance. A plurality of connection ports are disposed on the surfaces that are of the two circuit boards and that face each other. The connection ports can be used for plug-connection of wires, signal lines, and the like between the two circuit boards. The distance between the two circuit boards may be used for accommodating the foregoing connection ports, the wires, the signal lines, and the like.

Structures of the two circuit boards 10 are similar. To be specific, a plurality of heating elements 20 are disposed on each of the circuit boards 10, a substrate 30 is spaced apart from the circuit board 10, a potting compound 52 is disposed between the circuit board 10 and the substrate 30, and a heat conductor 50 is disposed between the heating elements 20 and extends from the substrate 10 to one side of the circuit board 10. Different from the foregoing examples, the substrate 10 in FIG. 14 is provided with a step portion 30'. In this way, a height of heat dissipation fins disposed on the step portion may vary with a height of the step portion. To ensure overall aesthetics of the circuit assembly, top ends of the heat dissipation fins may be located at a same height.

In this application, heat dissipation of the heat dissipation apparatus 100 is similar to a water absorption principle for a root system of a big tree. For example, the heat dissipation apparatus shown in FIG. 14 is used as an example for description. The heating elements 20 may be considered as a water source, the thermally conductive potting compound 52 may be considered as soil, the heat conductors 50 distributed in the thermally conductive potting compound 52 may be considered as the root system of the big tree, the substrate 30 may be considered as a trunk of the big tree, and the heat dissipation fins 31 may be considered as leaves of the big tree. Therefore, when heat dissipation is performed by using the heat dissipation apparatus 100 in this application, heat (moisture) of the heating elements 20 (the water source) is transferred to the substrate 30 (the trunk) by using the heat conductor 50 (the root system), and then is sufficiently dissipated into an external environment by using the substrate 30 (the trunk) and the heat dissipation fins 31 (the leaves), so that the heat dissipation apparatus 100 has a relatively good heat dissipation effect.

In some other examples, refer to FIG. 15. The heat dissipation apparatus 100 may further include a side plate 53, to facilitate potting on the substrate by using the thermally conductive potting compound 52.

### Embodiment 3

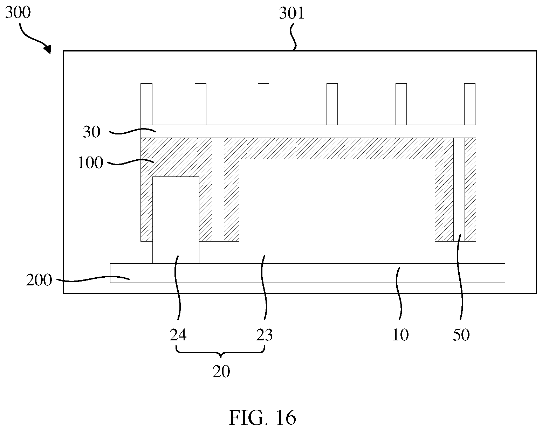

This embodiment of this application provides an electronic device. Refer to FIG. 16. An electronic device 300 includes a housing 301 and the foregoing circuit board assembly 200. The circuit board assembly 200 is disposed inside the housing 301.

Structures, functions, working principles, and the like of the heat dissipation apparatus and the circuit board assembly have been described in detail in Embodiment 1 and Embodiment 2, and details are not described herein again.

In this embodiment of this application, a plurality of heating elements 20 are disposed on a circuit board 10 of the electronic device. To perform heat dissipation on the heating elements 20, the heat dissipation apparatus 100 includes a substrate 30. The substrate 30 is disposed opposite to one surface that is of the circuit board 10 and that is provided with heating elements 20. In addition, to rapidly transfer heat on the heating elements 20 to the substrate 30, at least one heat conductor 50 is disposed on one surface that is of the substrate 30 and that faces the circuit board 10, and the heat conductor 50 extends to the circuit board 10 and is close to the heating elements. One end of the heat conductor 50 is connected to the substrate 30, and the other end of the heat conductor 50 extends toward the circuit board 10 and is close to the heating elements 20. In this way, heat of each heating element, especially a heating element with a relatively small size, can be rapidly transferred to the substrate 30 by using the heat conductor 50 with relatively small thermal resistance, and then is dissipated from the substrate 30 into an external environment. This effectively reduces thermal conduction resistance from the heating element to the substrate 30, and improves heat dissipation efficiency of each component in the electronic device.

The electronic device provided in this embodiment of this application includes, but is not limited to, mobile or fixed terminals with a circuit board, such as a mobile phone, a tablet computer, a notebook computer, an ultra-mobile personal computer (ultra-mobile personal computer, UMPC), a handheld computer, a walkie-talkie, a netbook, a POS machine, a personal digital assistant (personal digital assistant, PDA), an event data recorder, a wearable device, or a virtual reality device.

In the description of embodiments of this application, it should be noted that, the terms "mounting", "connection", and "connect" should be understood in a broad sense unless otherwise expressly stipulated and limited. For example, "connection" may be a fixed connection, an indirect connection through an intermediate medium, internal communication between two elements, or an interaction relationship between two elements. Persons of ordinary skill in the art may understand specific meanings of the terms in embodiments of this application based on specific cases.

In the specification, claims, and accompanying drawings of embodiments of this application, the terms "first", "second", "third", "fourth", and so on (if existent) are intended to distinguish between similar objects but do not necessarily indicate a specific order or sequence.

Finally, it should be noted that, the foregoing embodiments are merely intended for describing but not limiting the technical solutions of embodiments of this application. Although embodiments of this application are described in detail with reference to the foregoing embodiments, a person of ordinary skill in the art should understand that he/she may still make modifications to the technical solutions described in the foregoing embodiments or make equivalent replacements to some or all technical features thereof, provided that these modifications or replacements fall within the scope of the invention, which is defined by the appended claims.

## Claims

1. A circuit board assembly, comprising a circuit board (10) provided with a plurality of heating elements (22) and a heat dissipation apparatus, wherein the heat dissipation apparatus comprises a substrate (30), at least one heat conductor (50) is disposed on one surface that is of the substrate (30) and that faces the circuit board (10), one end of the heat conductor (50) is connected to the substrate (30), and the other end of the heat conductor (50) extends toward the circuit board (10) and is close to the heating elements (22); wherein the heat dissipation apparatus is disposed on one surface that is of the circuit board (10) and that is provided with the heating elements (22),
wherein one end of at least one heat conductor (50) in the heat dissipation apparatus extends between a high-temperature element (23) and a low-temperature element (24) that are adjacent in the heating elements (22), to isolate the high-temperature element (23) from the low-temperature element (24) by using the heat conductor (50);
**characterized in that** a heat insulation layer is disposed on the heat conductor (50) between the high-temperature element (23) and the low-temperature element (24), and the heat insulation layer faces the low-temperature element (24).

2. The circuit board assembly according to claim 1, wherein the circuit board (10) is a double-sided board, and the heat dissipation apparatus is disposed on both front and back surfaces of the circuit board (10).

3. The circuit board assembly according to claim 1, wherein the heat conductor (50) is an annular heat conductor, and the annular heat conductor is disposed by enclosing an outer side of the high-temperature element (23) adjacent to the low-temperature element (24), or a plurality of spaced heat conductors are disposed on an outer side of the high-temperature element (23) adjacent to the low-temperature element (24).

4. The circuit board assembly according to any one of claims 1 to 3, wherein a distance between the circuit board (10) and one end that is of the heat conductor and that is close to the circuit board (10) is less than a minimum distance between one end that is of the heating element (22) and that faces the substrate (30) and the circuit board (10).

5. The circuit board assembly according to any one of claims 1 to 4, wherein the heat dissipation apparatus further comprises a thermally conductive potting compound, wherein the thermally conductive potting compound is disposed on at least the one surface that is of the substrate (30) and that faces the circuit board (10), the heat conductor (50) is located inside the thermally conductive potting compound, and the heating element (22) at least partially extends into the thermally conductive potting compound.

6. The circuit board assembly according to claim 5, wherein a thermal conductivity of the heat conductor (50) is greater than a thermal conductivity of the thermally conductive potting compound.

7. The circuit board assembly according to claim 5 or 6, wherein there is a distance between the circuit board (10) and one surface that is of the thermally conductive potting compound and that faces the circuit board (10), or the thermally conductive potting compound fills space between the circuit board (10) and the substrate (30).

8. The circuit board assembly according to any one of claims 1 to 7, wherein an extending direction of the heat conductor (50) is perpendicular to the circuit board (10).

9. The circuit board assembly according to any one of claims 1 to 8, wherein the at least one heat conductor (50) is at least one of a thermal conductive sheet, a thermal conductive plate, a thermal conductive pillar, a thermal conductive root system, or a thermal conductive wire made of a high-thermal-conductivity material.

10. The circuit board assembly according to claim 9, wherein
the thermal conductive wire is a flexible thermal conductive wire; or
there are at least two heat conductors, and the at least two heat conductors are disposed in an intersecting manner; or
the thermal conductive wire is a flexible thermal conductive wire, there are at least two heat conductors, and the at least two heat conductors are disposed in an intersecting manner.

11. The circuit board assembly according to claim 9 or 10, wherein a cross-sectional shape of the heat conductor (50) is a square, a circle, or an oval.

## Patentansprüche

1. Leiterplattenanordnung, die eine Leiterplatte (10), die mit mehreren Heizelementen (22) ausgestattet ist, und eine Wärmeableitungseinrichtung umfasst, wobei die Wärmeableitungseinrichtung ein Substrat (30) umfasst, wenigstens ein Wärmeleiter (50) auf einer Oberfläche des Substrats (30), die der Leiterplatte (10) zugewandt ist, angeordnet ist, ein Ende des Wärmeleiters (50) mit dem Substrat (30) verbunden ist und sich das andere Ende des Wärmeleiters (50) in Richtung zur Leiterplatte (10) erstreckt und sich in der Nähe der Heizelemente (22) befindet, wobei die Wärmeableitungseinrichtung auf einer Oberfläche der Leiterplatte (10), die mit den Heizelementen (22) ausgestattet ist, angeordnet ist,
wobei sich ein Ende des wenigstens einen Wärmeleiters (50) in der Wärmeableitungseinrichtung zwischen einem Hochtemperaturelement (23) und einem Niedertemperaturelement (24), die in den Heizelementen (22) benachbart sind, erstreckt, um das Hochtemperaturelement (23) von dem Niedertemperaturelement (24) unter Verwendung des Wärmeleiters (50) zu isolieren;
**dadurch gekennzeichnet, dass** auf dem Wärmeleiter (50) zwischen dem Hochtemperaturelement (23) und dem Niedertemperaturelement (24) eine Wärmeisolationsschicht angeordnet ist und die Wärmeisolationsschicht dem Niedertemperaturelement (24) zugewandt ist.

2. Leiterplattenanordnung nach Anspruch 1, wobei die Leiterplatte (10) eine doppelseitige Platine ist und die Wärmeableitungseinrichtung sowohl auf der Vorder- als auch auf der Rückseite der Leiterplatte (10) angeordnet ist.

3. Leiterplattenanordnung nach Anspruch 1, wobei der Wärmeleiter (50) ein ringförmiger Wärmeleiter ist und der ringförmige Wärmeleiter durch Umschließen einer Außenseite des Hochtemperaturelements (23) benachbart dem Niedertemperaturelement (24) angeordnet ist oder mehrere beabstandete Wärmeleiter auf einer Außenseite des Hochtemperaturelements (23) benachbart dem Niedertemperaturelement (24) angeordnet sind.

4. Leiterplattenanordnung nach einem der Ansprüche 1 bis 3, wobei ein Abstand zwischen der Leiterplatte (10) und einem Ende des Wärmeleiters, das sich in der Nähe der Leiterplatte (10) befindet, kleiner ist als ein kleinster Abstand zwischen einem Ende des Heizelements (22), das dem Substrat (30) zugewandt ist, und der Leiterplatte (10).

5. Leiterplattenanordnung nach einem der Ansprüche 1 bis 4, wobei die Wärmeableitungseinrichtung ferner eine wärmeleitende Vergussmasse umfasst, wobei die wärmeleitende Vergussmasse auf wenigstens der einen Oberfläche des Substrats (30), die der Leiterplatte (10) zugewandt ist, angeordnet ist, sich der Wärmeleiter (50) innerhalb der wärmeleitenden Vergussmasse befindet und sich das Heizelement (22) wenigstens teilweise in die wärmeleitende Vergussmasse erstreckt.

6. Leiterplattenanordnung nach Anspruch 5, wobei eine Wärmeleitfähigkeit des Wärmeleiters (50) größer ist als eine Wärmeleitfähigkeit der wärmeleitenden Vergussmasse.

7. Leiterplattenanordnung nach Anspruch 5 oder 6, wobei ein Abstand zwischen der Leiterplatte (10) und einer Oberfläche der wärmeleitenden Vergussmasse, die der Leiterplatte (10) zugewandt ist, vorhanden ist oder die wärmeleitende Vergussmasse den Raum zwischen der Leiterplatte (10) und dem Substrat (30) füllt.

8. Leiterplattenanordnung nach einem der Ansprüche 1 bis 7, wobei eine Erstreckungsrichtung des Wärmeleiters (50) senkrecht zur Leiterplatte (10) ist.

9. Leiterplattenanordnung nach einem der Ansprüche 1 bis 8, wobei der wenigstens eine Wärmeleiter (50) wenigstens eines aus einem wärmeleitenden Blech, einer wärmleitenden Platte, einer wärmeleitenden Säule, einem wärmeleitenden Wurzelsystem oder einem wärmeleitenden Draht ist, das aus einem Material mit hoher Wärmeleitfähigkeit hergestellt ist.

10. Leiterplattenanordnung nach Anspruch 9, wobei
der wärmeleitende Draht ein flexibler wärmeleitender Draht ist, oder
wenigstens zwei Wärmeleiter vorhanden sind und die wenigstens zwei Wärmeleiter überschneidend angeordnet sind, oder
der wärmeleitende Draht ein flexibler wärmeleitender Draht ist, wenigstens zwei Wärmeleiter vorhanden sind und die wenigstens zwei Wärmeleiter überschneidend angeordnet sind.

11. Leiterplattenanordnung nach Anspruch 9 oder 10, wobei eine Querschnittsform des Wärmeleiters (50) ein Quadrat, ein Kreis oder ein Oval ist.

## Revendications

1. Ensemble carte de circuit imprimé, comprenant une carte de circuit imprimé (10) pourvue d'une pluralité d'éléments chauffants (22) et un appareil de dissipation de chaleur, l'appareil de dissipation de chaleur comprenant un substrat (30), au moins un conducteur de chaleur (50) étant disposé sur une surface qui est du substrat (30) et qui fait face à la carte de circuit imprimé (10), une extrémité du conducteur de chaleur (50) étant reliée au substrat (30), et l'autre extrémité du conducteur de chaleur (50) s'étendant vers la carte de circuit imprimé (10) et étant proche des éléments chauffants (22), l'appareil de dissipation de chaleur étant disposé sur une surface qui est de la carte de circuit imprimé (10) et qui est pourvue des éléments chauffants (22),
une extrémité d'au moins un conducteur de chaleur (50) dans l'appareil de dissipation de chaleur s'étendant entre un élément à haute température (23) et un élément à basse température (24) qui sont adjacents dans les éléments chauffants (22), afin d'isoler l'élément à haute température (23) de l'élément à basse température (24) à l'aide du conducteur de chaleur (50),
**caractérisé en ce qu'**une couche d'isolation thermique est disposée sur le conducteur de chaleur (50) entre l'élément à haute température (23) et l'élément à basse température (24), et **en ce que** la couche d'isolation thermique fait face à l'élément à basse température (24).

2. Ensemble carte de circuit imprimé selon la revendication 1, la carte de circuit imprimé (10) étant une carte à double face, et l'appareil de dissipation de chaleur étant disposé sur les surfaces avant et arrière de la carte de circuit imprimé (10).

3. Ensemble carte de circuit imprimé selon la revendication 1, le conducteur de chaleur (50) étant un conducteur de chaleur annulaire, et le conducteur de chaleur annulaire étant disposé en entourant un côté extérieur de l'élément à haute température (23) adjacent à l'élément à basse température (24), ou une pluralité de conducteurs de chaleur espacés étant disposés sur un côté extérieur de l'élément à haute température (23) adjacent à l'élément à basse température (24).

4. Ensemble carte de circuit imprimé selon l'une quelconque des revendications 1 à 3, une distance entre la carte de circuit imprimé (10) et une extrémité du conducteur de chaleur proche de la carte de circuit imprimé (10) étant inférieure à une distance minimale entre une extrémité de l'élément chauffant (22) faisant face au substrat (30) et la carte de circuit imprimé (10).

5. Ensemble carte de circuit imprimé selon l'une quelconque des revendications 1 à 4, l'appareil de dissipation de chaleur comprenant en outre un composé d'empotage thermoconducteur, le composé d'empotage thermoconducteur étant disposé sur au moins la surface qui est du substrat (30) et qui fait face à la carte de circuit imprimé (10), le conducteur de chaleur (50) étant situé à l'intérieur du composé d'empotage thermoconducteur, et l'élément chauffant (22) s'étendant au moins partiellement dans le composé d'empotage thermoconducteur.

6. Ensemble carte de circuit imprimé selon la revendication 5, une conductivité thermique du conducteur de chaleur (50) étant supérieure à une conductivité thermique du composé d'empotage thermoconducteur.

7. Ensemble carte de circuit imprimé selon la revendication 5 ou 6, une distance existant entre la carte de circuit imprimé (10) et une surface qui est du composé d'empotage thermoconducteur et qui fait face à la carte de circuit imprimé (10), ou le composé d'empotage thermoconducteur remplissant l'espace entre la carte de circuit imprimé (10) et le substrat (30).

8. Ensemble carte de circuit imprimé selon l'une quelconque des revendications 1 à 7, une direction d'extension du conducteur de chaleur (50) étant perpendiculaire à la carte de circuit imprimé (10).

9. Ensemble carte de circuit imprimé selon l'une quelconque des revendications 1 à 8, l'au moins un conducteur de chaleur (50) étant au moins l'un des éléments suivants : une feuille thermoconductrice, une plaque thermoconductrice, un pilier thermoconducteur, un système de racines thermoconductrices ou un fil thermoconducteur constitué d'un matériau à haute conductivité thermique.

10. Ensemble carte de circuit imprimé selon la revendication 9,
le fil thermoconducteur étant un fil thermoconducteur flexible ; ou
au moins deux conducteurs de chaleur existant, et les au moins deux conducteurs de chaleur étant disposés de manière à se croiser ; ou
le fil thermoconducteur étant un fil thermoconducteur flexible, au moins deux conducteurs de chaleur existant, et les au moins deux conducteurs de chaleur étant disposés de manière à se croiser.

11. Ensemble carte de circuit imprimé selon la revendication 9 ou 10, une forme de la section transversale du conducteur de chaleur (50) étant un carré, un cercle ou un ovale.
